# EUROPEAN PATENT APPLICATION

(11) **EP 1 380 541 A2**
(43) Date of publication of application: **14.01.2004**
(21) Application number: 03386017.2
(22) Date of filing: 08.07.2003
(51) Int. Cl.: C01G 3/00, C04B 35/45, H01L 39/12, H01L 39/24

(54) **A process for the production of very pure fine-grained superconducting powders**

(30) Priority: 10.07.2002 GR 2002100333
(71) Applicant: Cereco S.A., 34100 Chalkida (GR)
(72) Inventor: Andreouli, Constantina, 34100 Chalkida (GR); Tsetsekou, Athena, Xalandri Atenas (GR); Stournaras, Constantine, 34100 Chalkida (GR); Georgiopoulos, Elias, Papagou 15669 Athens (GR)

(57) **Abstract**

The present invention refers to the industrial scale production of very pure superconducting powders ReₓBa_{y}Cu_{z}O_{7-δ} (Re:Y or any rare earth element), through combination of the processes of spray drying and solid state reaction. The derived powders are used for the manufacturing of compact specimens or thermal sprayed coatings.
The method consists of a) production of stable aqueous suspensions after wet milling of the mix that contains the raw materials, the distilled water and appropriate binders and dispersants, b) Spray drying of the slurry for the production of dry powder and c) calcination of dry powder for the formation of the desired superconducting phase.
Under the optimized spray drying conditions, the use of slurries of metal oxides with very high solids content, leads to a process yield around 85-90% and extremely high productivity.
The produced powders are of high purity and are used for the production of compact samples or the production of thermal sprayed coatings.

## Description

The present invention relates to a high productivity process, for the production of very pure, fine-grained superconducting powders, using a spray drying technique. In particular, it refers to the production of powders of ReₓBa_{y}Cu_{z}O_{δ} family, where Re can be Y or a rare earth, for example Nd, Eu, Gd, Dy, Ho, Er.

Recently, ceramics superconductors can find a lot of applications, which however are not yet commercialized in a large scale.
A common prerequisite for all methods used for the production of superconducting materials, is the thorough mixing of the raw materials in order to produce relatively homogeneous ceramic products.
Up to now, various methods have been examined and are referred in the literature. The most common method for the production of YBa₂Cu₃C₇₋ₓ and similar high temperature superconductors is the solid state reaction of Y₂O₃, BaCO₃ and CuO mixture. This method comprises the steps of calcining the mixture, grinding the calcination product and repeating the steps of calcination and grinding to the point that the final product attains the desired purity. (D.W.Johnson, et al., "Fabrication of Ceramic Articles from High Tc Superconducting Oxides, published in Advanced Ceramic Materials,Vol. 2, No. 3B, Special Issue entitled "Ceramic Superconductors", Amer. Cer. Soc.(1987). Similar references by H.U.Krebs and R.Wördenweber, J.Appl.Phys., 63 (1988), p.1642.)

Today, some of the superconducting powders are commercially produced, utilizing mainly two methods. One method is the solid state reaction, as already mentioned. The other is a wet chemical method related to the coprecipitation from nitrate solutions for the production of homogeneous precipitates of the metal cations, which are subsequently thermally treated for the final powder production (Superconductive Components Inc.). Today, the most economical method for the production of superconducting powders in large quantities is the solid state reaction. However, this method is both time and energy consuming because of the need for numerous repetitions of the steps of calcination and grinding.
Several methods were used for the improvement of the properties of the produced superconducting powders based on the improvement of the homogeneity of the metallic salt precursors. Such methods are the sol-gel method, the freeze drying method and the spray drying method [K.Tanaka, A.Nozue, K.Kamiya, J.Mater.Sci., 25 (1990), p.3551] , [H.Medelius, D.J./Rowclife, Mater. Sci. Eng. A (1989), p.109], [M.Awano, M.Tanigawa, H.Takagi, Y.Torii, A.Tsuzuki, N.Murayama and E.Ishii, J.Ceram.Soc.Jpn.Inter.Ed. 96 (1988), p.417].

Spray Drying is a widely used method for the production of chemically homogeneous powders in large quantities. According to this method, the material is in the form of a solution or slurry and it is fed by spraying to a hot firing medium where it is converted to dry powder. The method allows the production of powders with controlled particle size distribution; the powders are chemically homogeneous with spherical grains, thus having good rheological properties. These characteristics render the powders deriving from spray drying, most suitable as raw materials for thermal spraying coatings or formation of specimens by pressing [E. Georgiopoulos, A. Tsetsekou and C. Andreouli, "Effect of YBCO powder characteristics on thick coatings prepared by Atmospheric Plasma Spraying", Supercond. Sci.Technol. Vol. 13 (2000), p.1539]. Regarding the production of superconducting powders by spray drying of nitrate solutions, high quality Y₁Ba₂Cu₃O_{δ} powders have been produced. [Hoste, S., Vlaeminck, H., DeRyck, P. H., Persyn, F., Mouton, R. & Van Der Kelen, G.P., Supercond. Sci. Techn., 1 (1989) 239; Tanaka, M., Hoste, S., Suzuki, M., Isobe, M. & Ami, T., Materials Letters, 15 (1993) 334], BiPbSrCaCuOₓ (2212 κατ 2223) [Van Driessche, I., Depla, D., Denu;, J., De Roo, N., De Gryse, R. & Hoste, S., Applied Superconductivity, 2 (1994) 391] κατ HgPb(BaSr)₂Ca₂Cu₃O_{z} [Lee, S., Kiryakov, N., Plesenkova, O., Emelyanov, D., Tretyakov, Y., Physica C, 282-287 (1997) 881 and Physica C, 290 (1997) 275].

The aim of the current invention is the industrial scale production of high purity superconducting ceramic powders, using the spray drying technique. Also, the aim of the current invention is the production of compact specimens and thermally sprayed coatings using the above mentioned powders. The current invention specifically refers to the production of fine-grained powders of ReₓBa_{y}Cu_{z}O_{7-δ} family, where Re may be Y or some of the rare earths (e.g. Nd, Eu, Gd, Dy, Ho, Er, e.t.c.). This invention allows the industrial scale production of ReₓBa_{y}Cu_{z}O_{7-δ} type of powders, of high chemical homogeneity, with spherical shape and fine-grained structure, controlled particle size distribution and very good rheological properties.

The production of YBa₂Cu₃O_{7-δ} powders and compact specimens that exhibit high homogeneity and pure supeconducting phase, by using slurries and methods such as spray drying, has also been patented by O'Bryan, Jr., et al. (EP 0 415 646 A1). They concluded that the agglomeration of high density components, such as CuOₓ, leads, after calcination, to segregation, therefore to inhomogeneous powders. In order to avoid this, according to their patent, they keep the milled slurry under continuous agitation throughout the duration of spray drying.
The present invention uses spray drying and afterwards the conventional solid state reaction process for the production of homogeneous powders. What differentiates the present invention and makes it attractive for full scale industrial production is that through the incorporation of appropriate binder and dispersant in appropriate content, it is possible to produce very stable slurries, with high solids content, without the risk of sedimentation, even without continuous agitation. By using very stable slurries, the risk of segregation is eliminated and the production of very homogeneous powders with very good stoichiometry control is possible. Thus, the present invention is further extended, besides the production of powders of the ReBa₂Cu₃O_{7-δ} type, also in the production of powders of the ReₓBa_{y}Cu_{z}O_{7-δ} type.

It is of importance that our research pointed out that the process yield is strongly dependent upon the drying parameters and that by correctly selecting these parameters, it is feasible to attain extremely high yield and therefore, the high method productivity is ensured, thus making the process ideal for industrial production.

The suspensions of metal oxides are produced by wet milling, using: a) stoichiometric quantities of the metal oxides based on Re (where Re: Y or any other rare earth metal), on Ba and on Cu, b) deionized water, c) binder and d) dispersant. Initially, the precursor powders are weighted to the appropriate quantities and are placed in plastic bottles, in which deionized water is added as well as the binder and the dispersant. Finally, zirconia balls are added which are used as the grinding medium. The selected binder is an ammonium salt of polymethacrylic acid (Darvan) and the dispersant is a polyvinyl alcohol (PVA). In this way, it is possible to produce slurries with high solids content e.g. 75 wt.%, with very good rheological properties e.g. they exhibit low viscosity which is kept constant with time, thus enabling the method to be used for industrial scale production. Therefore, continuous agitation is not considered necessary, however a periodic agitation may be useful.
The produced dried powder is made of spherical agglomerates with fine-grained structure and is being collected in two fractions. The fine powder fraction is collected at the cyclone, whereas the coarser fraction is collected at the bottom of the spray drier.
Apart from the special characteristics of the produced dry powder, the study of the process yield, namely the percentage of the powder recovery, is also important. The use of metal oxides slurry leads to very high value of the percentage of powder recovery, which, for the optimized values of feed rate and air pressure, exceeds 85-90%. This, in conjunction with the high content in solids leads to an impressively high productivity.

The dry powder, produced from spray drying, is subjected to calcination in big furnaces under an oxidative atmosphere in the temperature range of 900-950°C for around 10 hrs.
The very low water content in the metal salts slurry, in conjunction with the low weight loss after calcination, makes this method extremely productive compared to ReₓBa_{y}Cu_{z}O_{7-δ} powder production from nitrate salts solutions.

What makes the current invention attractive for industrial scale production is that, apart from its high productivity, it produces powders, which are of very high purity. As an example, for YBa₂Cu₃O₇₋ₓ powder produced by the method of solid state reaction, numerous repetitive steps of sintering and grinding are required so as to finally produce high purity powder. Also, powder produced by the spray drying of nitrate salts contains (after calcination), apart from the YBa₂Cu₃O₇₋ₓ superconducting phase, other secondary phases. Contrasting to the previously mentioned methods, it is possible with the present method, to have ultra pure superconducting powders, using only one sintering step.

The powders deriving after calcination may be used either for the production of compact specimens or for the production of thermally sprayed coatings. Whenever required, the powder after calcination is ground using as grinding media zirconia balls and a solvent such as ethyl alcohol.
This powder may be compacted in various shapes, followed by sintering in oxygen atmosphere within the temperature range 900-960°C, depending on the requirements on the specimen's density. During cooling, it is essential to anneal within the temperature range 400-600 °C, depending on the exact ReBa₂Cu₃O₇₋ₓ powder system, so as to achieve the orthorhombic superconducting structure.

Also, the powders produced after calcination may be used for the production of thermally sprayed coatings by applying techniques such as atmospheric plasma spraying, vacuum plasma spraying as well as high velocity oxygen-fuel spraying. After thermal spraying, heat treatment of the substrate-coating system may be performed to regain the desired phases. For example, the coating produced by thermal spraying of YBa₂Cu₃O₇₋ₓ powder does not comprise only the superconducting phase but a variety of other phases. After heat treatment stage of the substrate-coating system within the temperature range 880-950 °C in an oxygen atmosphere, the coating has regained the superconducting phase and it comprises only the pure YBa₂Cu₃O₇₋ₓ phase.

The following example serves to further elucidate the current invention

### Example 1

Slurries of metal oxides are produced, which contain stoichiometric quantities of: Y₂O₃ (Cerac, 99.9% purity), BaCO₃ (Fluka, 98.5% purity) κατ CuO (Sigma Aldrich, 98% purity). The particle size analysis of the raw materials is of the order of 5µm. After mixing the raw materials, deionized water, the binder and the dispersant are added and wet milling takes place in plastic bottles for around 15 hrs. in equipment with rotational speed of around 100 RPM. The slurries have 75 wt.% of solids and 25 wt.% of deionized water, whereas the dispersant added was 0.5 wt.% of the slurry and the binder added was 4 wt.%.
For the spray drying process, a spray drier of semi-industrial scale was used (ICF, model 1C/5 DF-T) with water evaporation rate capacity 6l/h and a pressure nozzle with 0.5mm diameter.
The inlet air temperature was 180°C-200°C whereas the outlet air temperature was 100°C-120°C. Around 70-80% of the totally produced powder is the fine powder fraction, which is collected at the cyclone and has an average spherical grain size of around 20-40µm, whereas the 20-30% of the totally produced powder is the coarse powder fraction, which is collected at the bottom of the drier and has an average spherical grain size of around 60-80µm.
The use of metal oxides slurry leads to a very high percentage of the regained powder, which under the optimized conditions of feed rate and air pressure exceeds 85-90%. This, in conjunction with the fact that slurries of very high content in solids are used leads to spectacularly high process yield, around 5kg of powder per hour of spray drier operation.
The produced spray dried Y-Ba-Cu-O powder undergoes calcination in big furnaces in air atmosphere. For a quantity of about 1 kg spray dried powder, calcination takes place in the temperature range of 920°C for around 10 hrs. to finally produce the pure superconducting YBa₂Cu₃O_{7-δ} phase. For the formation of the superconducting YBa₂Cu₃O_{7-δ} phase the weight loss during calcination is only 12%, whereas for example, in the case of nitrate salts, the weight loss reaches 50%, due to the fact that they are hydrous salts.
Therefore, for 1 hour operation of the spray dryer, under the optimized conditions: a) More than 5 kg of dry powder may be produced from a slurry of metal oxides, which, after sintering, will yield around 4.5 kg YBa₂Cu₃O_{7-δ}, whereas b) from a solution of nitrate salts around 150 gr of dry powder may be produced, which, after sintering, will yield around 75gr of YBa₂Cu₃O_{7-δ}.

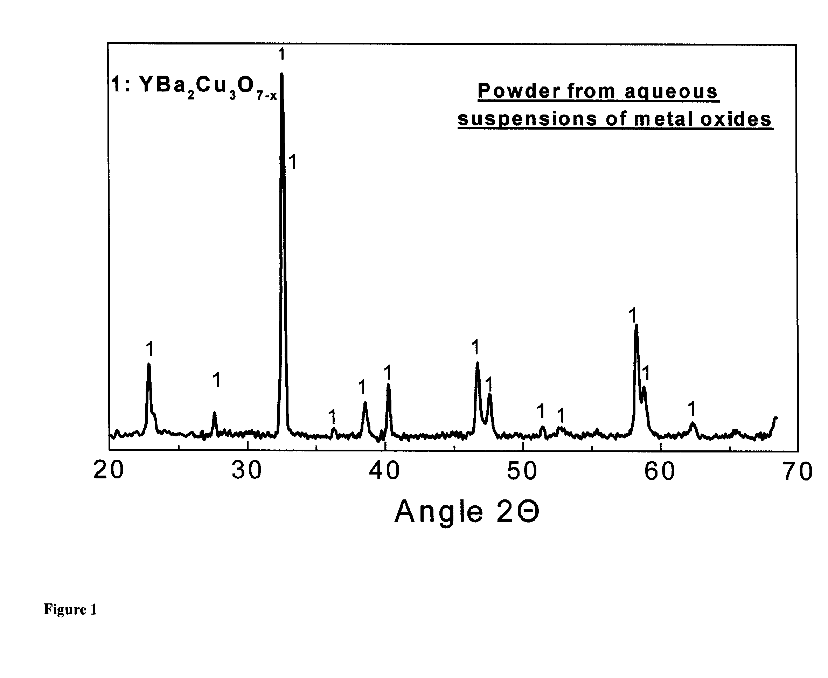

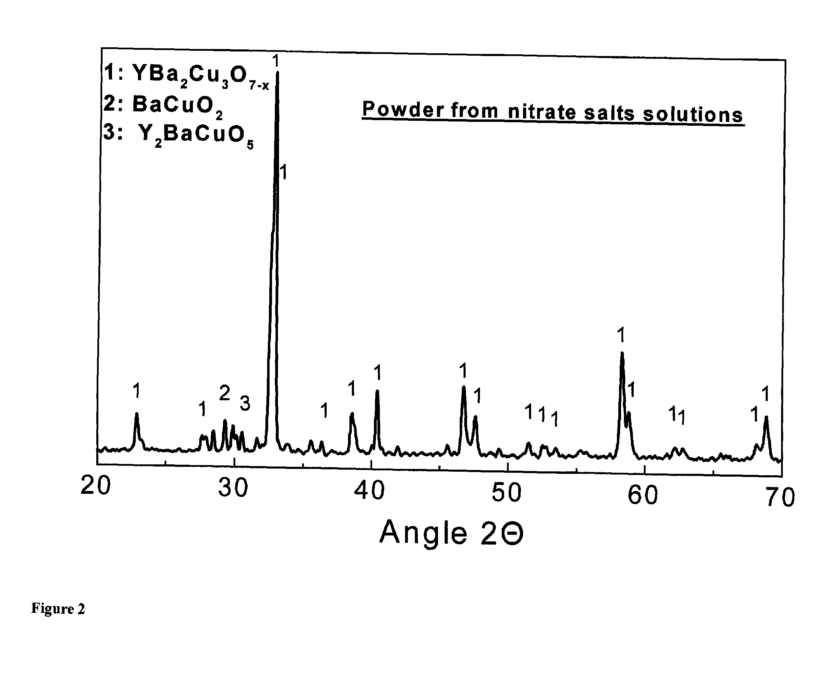

For the production of the superconducting YBa₂Cu₃O_{7-δ} powder, the powder produced after calcination under the optimized conditions, using spray drying metal oxides slurry, it is of very high purity since only the YBa₂Cu₃O_{7-δ} phase is detected at the X-Ray Diffractographs. Figure 1 presents an X-ray diffractograph of powder, which, after being produced by spray drying of metal oxides slurry, was calcined under the optimized conditions. Comparatively, the powder produced by spray drying of nitrate salts solutions and subsequently calcined under the optimized conditions, present secondary phases apart from the YBa₂Cu₃O_{7-δ} superconducting phase. Figure 2 presents an X-ray diffractograph of such a powder, which after being produced by spray drying of nitrate salts solution, was calcined under the optimized conditions.

## Claims

1. A process for the production of very pure, fine-grained superconducting ceramic ReₓBa_{y}Cu_{z}O_{7-δ} powders (where Re: Y or any other rare earth metal), which comprises the following steps:
a) Production of very stable aqueous suspension with high solids content, using the appropriate binder and dispersant and without any need for continuous agitation. Use of wet milling of the aqueous slurry, which contains the predetermined proportions of raw materials to obtain the desired stoichiometry at the final powder products
b) Only periodic agitation of the ground aqueous slurry to avoid sedimentation
c) Spray drying of the milled aqueous slurry for the production of dry powder
d) Calcination of the dry powder for the formation of the desired superconducting phase at the final powder product

2. The process of claim 1, in which the aqueous slurry includes: i) an ammonium salt of polymethylacrylic acid (Darvan) as dispersant, ranging in between 0.2 and 2.0 wt.% and ii) a polyvinyl alcohol (PVA) as binder, ranging in between 1 and 1.5 wt.%.

3. The process of claim 1, in which the starting raw materials of the aqueous slurry comprise Re compounds (where Re:Y or any other rare earth metal), Ba compounds and Cu compounds in the stoichiometric ratio of x:y:z.

4. The process of claim 1, in which for spray drying, a pressure nozzle is used, having diameter in between 0.5mm and 5mm.

5. The process of claim 1, in which the powder is produced at extremely high productivity.

6. The process of claim 1, in which the final powder is produced by calcination at a temperature range in between 900 °C and 950°C for a duration around 10hrs.

7. The process of claim 1, in which the final powder is 100% pure, as detected by X-Ray diffraction.

8. The process of claim 6, in which the produced powder is used for the production of compact ReₓBa_{y}Cu_{z}O_{7-δ} specimens, comprising the following steps: a) Shaping, b) sintering in oxygen atmosphere within the temperature range of 900 °C - 960°C and c) annealing during cooling in an oxygen atmosphere within the temperature range of 400 °C - 600°C, whenever there is a requirement for high oxygen content.

9. The process of claim 6, in which the produced powder is used for producing thermal sprayed coatings by the methods of atmospheric plasma spraying, vacuum plasma spraying and high velocity oxygen-fuel spraying.

10. The process of claim 9, in which the thermal sprayed coating, is sintered within the temperature range of 880 °C - 950°C in an oxygen environment, so as to regain the desired phase of the powder used for thermal spraying.
